(19) Europäisches Patentamt
European Patent Office
Office européen des brevets

(11) **EP 2 345 071 B1**

(12) **EUROPEAN PATENT SPECIFICATION**

(45) Date of publication and mention
of the grant of the patent:
**01.05.2013 Bulletin 2013/18**

(21) Application number: **09816537.6**

(22) Date of filing: **23.09.2009**

(51) Int Cl.:
*G11C 13/00* (2006.01)     *G11C 11/22* (2006.01)
*G11C 11/56* (2006.01)     *H01L 29/786* (2006.01)
*G11C 13/02* (2006.01)     *H01L 29/16* (2006.01)
*H01L 27/115* (2006.01)

(86) International application number:
**PCT/SG2009/000352**

(87) International publication number:
**WO 2010/036210 (01.04.2010 Gazette 2010/13)**

(54) **GRAPHENE MEMORY CELL AND FABRICATION METHODS THEREOF**

GRAPHENSPEICHERZELLE UND HERSTELLUNGSVERFAHREN DAFÜR

CELLULE MÉMOIRE À BASE DE GRAPHÈNE ET SES PROCÉDÉS DE FABRICATION

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(30) Priority: **23.09.2008 US 192967 P
26.06.2009 US 269629 P**

(43) Date of publication of application:
**20.07.2011 Bulletin 2011/29**

(73) Proprietor: **National University of Singapore
Singapore 119077 (SG)**

(72) Inventors:
• **OEZYILMAZ, Barbaros**
**Singapore 119077 (SG)**
• **ZHENG, Yi**
**Singapore 119077 (SG)**
• **NI, Guang, Xin**
**Singapore 119077 (SG)**
• **TOH, Chee, Tat**
**Singapore 119077 (SG)**

(74) Representative: **Talbot-Ponsonby, Daniel
Frederick
Marks & Clerk LLP
Fletcher House
Heatley Road
The Oxford Science Park
Oxford OX4 4GE (GB)**

(56) References cited:
WO-A1-2009/140596

• **Peter C. Eklund et al.: "Graphene Electronics",
NSF Nanoscale Science and Engineering
Grantees Conference, grant ECS0609243 ,
December 2007 (2007-12), XP002667730,
Retrieved from the Internet: URL:http:
//www.nseresearch.org/2007/overvi ews/
0609243_Eklund.doc [retrieved on 2012-01-23]**
• **ZHENG YI ET AL: "Gate-controlled nonvolatile
graphene-ferroelectric memory", APPLIED
PHYSICS LETTERS, AIP, AMERICAN INSTITUTE
OF PHYSICS, MELVILLE, NY, US, vol. 94, no. 16,
22 April 2009 (2009-04-22), pages 163505-163505,
XP012121011, ISSN: 0003-6951, DOI:
10.1063/1.3119215**
• **YI ZHENG ET AL: "Graphene Field-effect
Transistors with Ferroelectric Gating",
PHYSICAL REVIEW LETTERS AMERICAN
PHYSICAL SOCIETY USA, vol. 105, no. 16, 15
October 2010 (2010-10-15), XP002667697, ISSN:
0031-9007**
• **HONG. ET AL.: 'High mobility multi-layer
graphene field effect transistors fabricated on
epitaxial ferroelectric gate oxides' L5TH
INTERNATIONAL WORKSHOP ON OXIDE
ELECTRONICS, ESTES PARK, CO 17 September
2008, pages 136808-1 - 136808-4, XP008146768**
• **ECHTERMEYER. ET AL.: 'Non-volatile switching
in graphene field effect devices' IEEE ELECTRON
DEVICE LETTERS vol. 29, no. 8, August 2008,
pages 952 - 954, XP008146770**

**Description**

**FIELD OF THE INVENTION**

The present invention relates generally to a non-volatile memory cell and methods of fabricating a non-volatile memory cell. In particular the present invention relates to a non-volatile graphene-based memory cell and methods of fabrication thereof.

**BACKGROUND OF THE INVENTION**

Memories and in particular non-volatile memories are in great demand for high-performance digital cameras, mp3 players, flash drives and cards, mobile phones, personal digital assistants (PDAs) and ultra-portable notebook personal computers (PCs) where high-density, ultra-compact, and low power-consumption storage devices are needed to replace the use of bulky hard disk drives.

An example non-volatile memory is NAND flash memory. In essence, each memory cell of a NAND flash memory comprises a silicon metal-oxide-semiconductor field-effect transistor (Si MOSFET) with an extra gate (called a floating gate) in addition to a control gate. The floating gate is surrounded by an insulating layer, which serves to trap any charge that is inserted into the floating gate by hot electron tunneling. The presence or absence of charge in the floating gate affects the current flow through the MOSFET channel, and this is sensed to determine whether the memory cell holds a '1' or '0' data value.

NAND flash memory has grown into a billion dollar industry in recent years because of its faster speed and more compact structure than hard disk drives, simple circuit design, and fast-increasing capacity due to its aggressive scalability. The main disadvantage of NAND flash is its slow random access time, which is $25\mu$s for the first byte. NAND flash also has limited write-erase-cycles, which is 100,000 cycles for block 0 and no guarantees for other blocks. Another disadvantage related to NAND flash is the necessity of 'block erasure', which means that although each bit of NAND flash can be changed from 1 to 0, a whole block (2112 bytes) must be erased to 1 if one bit of the specific block needs to be converted from 0 to 1 NAND flash also needs high voltages (20V) for writing and erasing processes.

Another non-volatile memory is ferroelectric RAM (FeRAM), which utilizes ferroelectric capacitors for data storage. In FeRAM, '1' and '0' data values are represented by two opposite polarization states, which can be retained without electrical power. Unlike NAND flash, FeRAM only needs a marginally higher writing voltage than the reading voltage. Moreover, both read and write can be done in a bit-by-bit fashion in FeRAM. These two features allow FeRAM to have less power consumption than NAND flash, with a more balanced read and write operation. The speed of FeRAM is comparable with dynamic random access memory (DRAM) but much faster than NAND flash. Reading of a FeRAM cell is carried out by forcing the cell into a particular state (e.g. a '0' state). If the cell already held a '0', no change will be observed at the output lines. If the cell held a '1', the forcing into the opposite state causes a brief pulse of current at the output lines. The data value of the cell is thus determined from the presence or absence of this pulse. The main disadvantage of FeRAM, however, is that the reading process of the '1' state is destructive, and a following re-writing process is required to get the state back to '1'. Also, the scalability of FeRAM is still unclear.

Hong et al. "High mobility multi-layer graphene field effect transistors fabricated on epitaxial ferroelectric gate oxides", 15th International Workshop on Oxide Electronics, ESTES Park, Co, 17 September 2008 pages 136808-1 to 136808-4, XP008146768, discusses improvements carrier mobility in few-layer graphene field effect transistors fabricated using crystalline ferroelectric gate oxide PZT. Echtermeyer et. al. "Non-volatile switching in graphene field effect devices", IEEE Electron Device Letters, vol. 29, no 8, August 2008, pages 952-954, XP008146770, discloses an approach to engineer a band gap in graphene field-effect devices (FEDs) by controlled structural modification of the graphene channel itself.

Peter C. Eklund et. al. "Graphene Electronics', NSF Nanoscale Science and Engineering Grantees Conference, grant ECS0609243, 3-6, December 2007 (2001-12), SP002667730, discloses behaviour of non-volatile memory devices based on thin graphite field effect transistors with a ferroelectric film (PZT) as gate oxide. Further, WO 2009/140596 discloses methods of forming a microelectronic structure which includes a carbon nano-film, such as graphene. However, the operations and designs of these prior art devices are complex in particular when these devices are used for memory and data storage.

**SUMMARY OF THE INVENTION**

In general terms, the present invention relates to a non-volatile memory cell comprising graphene as the working medium. A non-volatile operation may be provided by switching the graphene using a ferroelectric layer as the gate dielectric.

In one specific expression, the present invention relates to a non-volatile memory cell comprising a graphene layer having controllable resistance states representing data values of the memory cell; and a ferroelectric layer configured to control the resistance states, characterized in that the graphene layer includes a background doping level ($n_{back}$) greater than zero and the background doping level ($n_{back}$) being introduced before polarization of the ferroelectric layer (18).

With the background doping level greater than zero, this allows a symmetrical writing process to be advantageously implemented. In one form, this allows the graphene layer to be in a high resistance state when a positive voltage pulse is applied to a top electrode of the memory cell, and in a low resistance state when a negative voltage pulse is applied to the top electrode. The background doping level may be achieved by providing the graphene layer as epitaxial graphene on a SiC substrate in one form. In another form, the graphene layer is doped with donor or acceptor molecules and is arranged on one surface of the ferroelectric layer, and with an electrode being formed on an opposite surface of the ferroelectric layer.

The background doping level is preferably controllable to adjust a resistance change ratio of the resistance states. This advantageously allows multiple resistance change ratios to be used to represent multiple bits of data.

Preferably, in a first form, the graphene layer is chemically derived from graphene oxide In a second form, the graphene layer is chemically modified graphene, such as graphane. In a third form, the graphene layer is grown by chemical vapor deposition (CVD), low pressure CVD, or plasma-enhanced CVD on copper, nickel, cobalt or any other surface, which allows for large-scale graphene. In a fourth form, the graphene layer is mechanically exfoliated from bulk graphite. In terms of thickness, the graphene layer may be one layer, two layers, three layers or any other gate tunable thickness.

Preferably the graphene layer is a pristine two-dimensional sheet, or patterned into nanoscale dimensions of dots, dot arrays, nanowires or nanowire arrays. The graphene layer may have an intrinsic energy band structure or a band gap engineered by lateral confinement, strain stress or electric field.

Preferably the graphene layer is gated by top gates, side gates, back gates or a combination of one or more of top gates, back gates and side gates.

Preferably the memory cell is fabricated on a flexible and/or transparent substrate.

Preferably the arrangement of the graphene layer is one selected from: directly in contact with the ferroelectric layer, and separated from the ferroelectric layer by an ultrathin insulating layer. Preferably the memory cell further comprises an alternating stack of graphene layer and ferroelectric layer, each layer being contacted (or contactable) separately. This is advantageous as it allows a three-dimensional memory architecture to be realized.

In another specific expression, the present invention relates to a method of fabricating a non-volatile memory cell comprising providing a graphene layer having controllable resistance states to represent data values of the memory cell; and providing a ferroelectric layer configured to control the resistance states, characterized in that the graphene layer includes a background doping level ($n_{back}$) greater than zero, and the method includes introducing the background doping level ($n_{back}$) before polarization of the ferroelectric layer (18)..

Preferably, in a first form, the providing step comprises arranging the graphene layer on a dielectric layer on a conducting substrate, and forming a ferroelectric thin film over the graphene layer. In this form, the method preferably further includes forming a top electrode on the ferroelectric thin film. In a second form, the providing step comprises forming a ferroelectric thin film on a dielectric on a conducting substrate, and arranging the graphene layer over the ferroelectric thin film. In this form, the method preferably further comprises forming a bottom electrode between the ferroelectric thin film and the dielectric layer. In a third form, the providing step comprises forming an epitaxial ferroelectric thin film on a conducting oxide, and arranging the graphene layer over the ferroelectric thin film. In this form, the conducting oxide functions as a bottom electrode.

Preferably the providing step comprises depositing the graphene layer on a ferroelectric substrate, and doping the graphene layer with donor or acceptor molecules. Alternatively or additionally, this may be achieved by growing epitaxial graphene on a SiC substrate. Ferroelectric background gating may also be used.

Preferably, in a first form, the providing step comprises chemically deriving the graphene layer from graphene oxide. In a second form, the providing step comprises chemically modifying graphane to provide the graphene layer. In a third form, the providing step comprises growing the graphene layer by chemical vapor deposition (CVD), low pressure CVD, or plasma-enhanced CVD on copper, nickel, cobalt or any other surface, which allows for large-scale graphene. In a fourth form, the providing step comprises mechanically exfoliating from bulk graphite. In terms of thickness, the graphene layer may be one layer, two layers, three layers or any other gate tunable thickness.

Preferably the providing step comprises providing the graphene layer as one layer, two layers, three layers or any other gate tunable thickness.

Preferably the providing step comprises providing the graphene layer as a pristine two-dimensional sheet, or patterning into nanoscale dimensions of dots, dot arrays, nanowires or nanowire arrays.

Preferably the providing step comprises providing the layers on a flexible and/or transparent substrate.

Preferably the providing step comprises providing the graphene layer directly in contact with the ferroelectric layer, or separating the graphene layer from the ferroelectric layer by an ultrathin insulating layer. Preferably the method further comprises forming an alternating stack of graphene layer and ferroelectric layer.

As will be apparent from the following description, embodiments of the present invention provide a non-volatile memory cell that benefits from a low bias writing and reading process, which accordingly reduces power consumption of devices using the memory cell. Furthermore, data readings from the memory cell of the present invention are not destructive, which avoids re-writing processes and thus increases switching time and reduces power usage. These factors when combined with various factors that will be later described result in a memory device that is capable of high performance, fast access times, high reliability, low power consumption and non-volatility. The present invention also provides a non-volatile memory solution for cost-effective flexible electronics by using flexible and/or transparent substrates and polymer ferroelectric. These and other related advantages will be readily apparent to skilled persons from the description below.

## BRIEF DESCRIPTION OF THE FIGURES

Non-limiting preferred embodiments of the memory cell will now be described with reference to the accompanying figures in which:

Figures 1A and 1B are a cross-section schematic and a perspective cutaway schematic respectively of one embodiment of the memory cell,

Figure 2 is a graph showing the field-dependent resistance of a graphene layer.

Figures 3A and 3B are resistance versus electric field graphs showing the resistance of the graphene layer at the zero polarization (i.e. bit '1') and at the non-zero polarization (i.e. bit '0'),

Figures 3C and 3D are two series of polarization versus electric field (P-E) hysteresis loops showing the writing of a '1' state into the memory cell from different initial states,

Figures 3E and 3F are two series of polarization versus electric field (P-E) hysteresis loops showing the writing of a '0' state into the memory cell from different initial states,

Figures 4A and 4B are cross-section schematics of alternative embodiments of the memory cell,

Figure 4C is a perspective cutaway schematic of a flexible memory cell using a flexible and/or transparent substrate and polymer ferroelectric,

Figure 5 is a graph showing the hysteresis loop of graphene resistance versus gate voltage for a graphene-ferroelectric memory cell with a gate voltage sweep between -85V and 85V,

Figures 6A to 6D are graphs showing the hysteresis loops of graphene resistance versus gate voltage for effecting various data value changes, i.e. bit writing in the memory cell,

Figures 7A and 7B are cross-section schematics, hysteresis loops and graphs of a non-electrostatic biased memory cell and an electrostatic biased memory cell respectively,

Figures 8A to 8C are cross-section schematics and hysteresis loops showing the change in the hysteresis loop following electrostatic bias, and the operation of writing a '1' and a '0' into the memory cell,

Figures 9A and 9B are cross-section schematics of two embodiments of the memory cell with electrostatic bias, and

Figure 10 is a graph of resistance change ratio versus background doping levels for multi-bit-per-cell data storage.

## DETAILED DESCRIPTION OF PREFERRED EMBODIMENTS

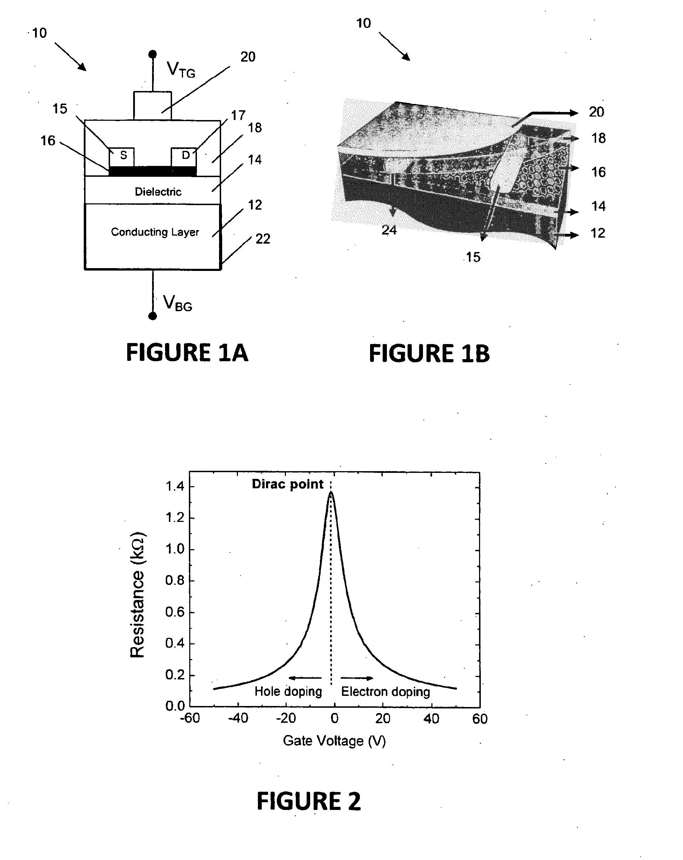

Referring to Figures 1A and 1B, one preferred embodiment of the memory cell 10 is shown. The memory cell 10 includes a conducting substrate 12 and a dielectric layer 14 on the conducting substrate 12. A graphene layer 16 comprising a graphene sheet is arranged over the dielectric layer 14 and is encapsulated by a ferroelectric layer 18 comprising a thin film of ferroelectric. The graphene layer 16 is electrically coupled to a source region 15 and a drain region 17 of the memory cell 10. A top electrode 20 that is electrically coupled to the ferroelectric layer 18 and a bottom electrode 22 (the conducting substrate) that is electrically coupled to the dielectric layer form two alternative gate regions of the memory cell 10. Contacts 24 are also provided on the graphene layer 16 for connection to and from the memory cell 10. The arrangement of the above layers results in a non-volatile memory cell having a sandwich structure of metal/ferroelectric/graphene, best depicted in Figure 1 B.

The graphene layer 16 comprises graphene, which is a layer of carbon atoms with a two-dimensional hexagonal crystal structure. It has been found that one of the unique properties of graphene is its field-dependent conductivity. Referring to the graph Figure 2, this field-dependent conductivity is shown as an inverted V-shape graph of differential resistance versus gating voltage. Depending on the electric field established by the gating voltage, charge carriers in graphene can be tuned continuously from holes to electrons crossing the minimum conduction point (i.e. the peak of the V-shape, also known as the Dirac point). As a result, when single graphene sheets are placed on a dielectric layer on a conducting substrate (e.g. silicon wafer) to form a graphene-dielectric-gate structure, bias applied to the conducting substrate with the graphene sheets grounded resulted in a change in the charge carrier concentration as well as conductivity.

The application of graphene in the present invention utilizes the field-dependent conductivity of graphene by representing data values using different resistance states of the graphene layer (cf. magnetic data storage). The different resistance states of graphene, however, cannot be retained as long as the external field is switched off. To overcome this volatile nature of the field-dependent electrical resistance, the present invention utilizes the remnant field of a ferroelectric layer to set a particular resistance state of the graphene layer. As will be explained below binary '0's and '1's are represented by the different resistance states of the graphene layer, and these states are switched in a non-volatile manner by the polarization magnitudes of the ferroelectric layer.

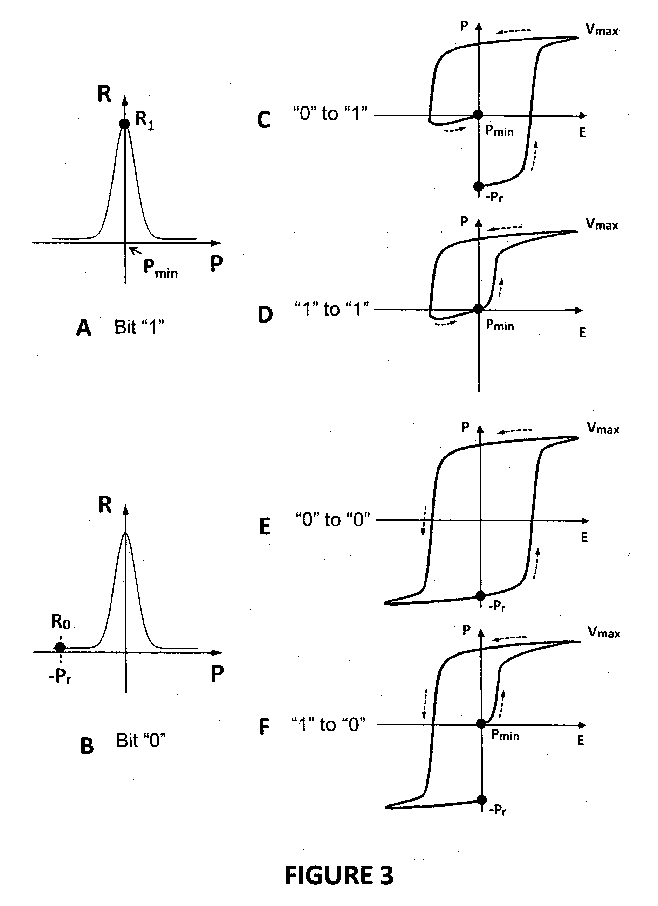

The operation of the above arrangement is shown in Figures 3A to 3F. Referring to the resistance versus polarization graphs of Figure 3A and 3B (which again show the field-dependent resistance of the graphene layer), the setting of the ferroelectric layer at a zero remnant polarization $P_{min}$ and a non-zero remnant polarization -P, result in two specific resistance state of the graphene layer. In the embodiment shown, the binary information is a high resistance state (having resistance $R_1$) representing the data value '1' and a low resistance state (having resistance $R_0$) representing the data value '0' respectively. When reading of the stored binary value is required, all that is necessary is to detect the resistance of the graphene layer. It will be appreciated that reading the data value is not destructive since the memory value is retained by the ferroelectric layer, which maintains the remnant polarization until such time as it is depolarized or polarized differently.

Figures 3C and 3D show the operation to write a binary value '1' into the preferred form memory cell. Referring to the graphs of Figure 3C and 3D, two different polarization versus electric field (P-E) hysteresis loops of the ferroelectric layer are shown. In Figure 3C, the ferroelectric layer is initially polarized with a remnant polarization of $-P_r$, while in the Figure 3D, the ferroelectric layer is initially polarized with a zero polarization. In both cases, the ferroelectric layer is subjected to a minor hysteresis loop with an asymmetrical $V_{TG}$ sweep from 0 to $V_{max}$, $V_{max}$ to $V_{Ec}$, and from $V_{Ec}$ back to 0. The minor hysteresis loops minimize the polarization in the ferroelectric layer and set the memory cell into bit '1', independent on the initial states. It will be appreciated that the remnant polarization is the result of electrical dipoles within the ferroelectric layer being aligned in one direction in response to the applied electric field, and Ec is the coercive field of the ferroelectric.

Referring now to Figures 3E and 3F, the operation to write a binary value '0' into the preferred form memory cell is shown. As before, Figures 3E and 3F show two different polarization versus electric field (P-E) hysteresis loops of the ferroelectric layer. In Figure 3E, the ferroelectric layer is initially polarized with a remnant polarization of $-P_r$, while in the Figure 3F, the ferroelectric layer is initially polarized with a zero polarization. To write bit '0', the ferroelectric layer is subjected to a major hysteresis loop with a symmetrical $V_{TG}$ sweep from 0 to $V_{max}$, $V_{max}$ to $-V_{max}$, and from $-V_{max}$ back to 0. The major hysteresis loops maximize the remnant polarization in the ferroelectric layer and set the memory cell into bit '0', also independent on the initial states. It has been found that a resistance change of at least an order of magnitude between the high resistance state and the low resistance state can be reproducibly achieved. As before, when reading of the stored value is required, all that is necessary is to detect the resistance of the graphene layer.

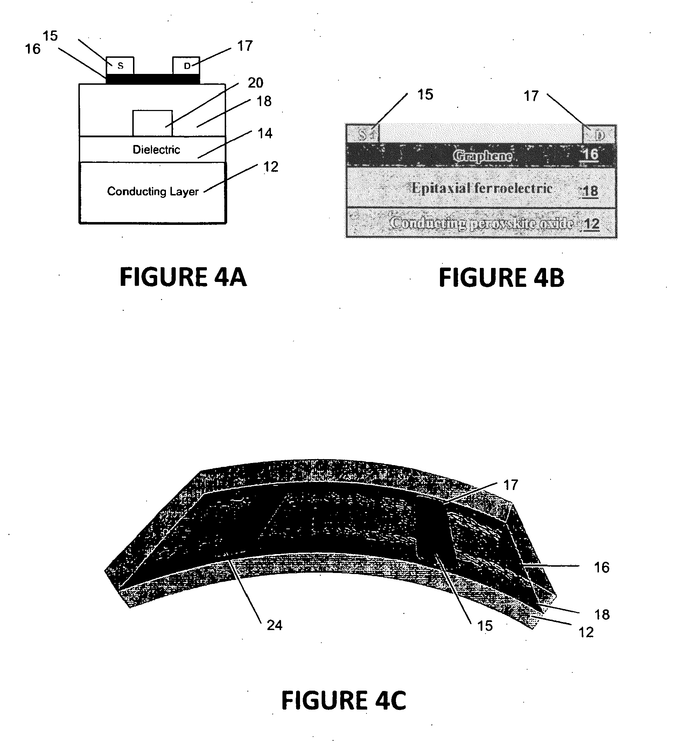

Alternative preferred embodiments of the memory cell are illustrated in Figures 4A and 4B. In Figure 4A, the ferroelectric layer 18 is provided on the dielectric layer 14 while in Figure 4B the ferroelectric layer 18 is provided on a conducting oxide layer 14, and the graphene layer 16 is provided over the epitaxial ferroelectric layer 18. The top electrode 20 in these arrangements underlies the ferroelectric layer 18 (i.e. between the ferroelectric layer 18 and the dielectric layer 14 in Figure 4A, and the conducting perovskite oxide layer 14 in Figure 4B). The arrangements of these embodiments allow thermal processing of the ferroelectric layer 18.

The fabrication of the memory cell in a volatile embodiment comprises providing a graphene layer having different resistance states representing data values. The fabrication of the memory cell in a non-volatile embodiment of the present invention comprises providing a graphene layer and a ferroelectric layer typically on a substrate (although one embodiment uses the ferroelectric layer as the substrate), with the ferroelectric layer being configured to controllably set the resistance state of the graphene layer. In one preferred embodiment, the memory cell is fabricated on a flexible and/or transparent substrate 12, as shown in Figure 4C. For the embodiment of Figure 1A, the method includes forming a bottom electrode using the conducting substrate 12, providing a graphene layer 16 on the conducting substrate 12, and providing a ferroelectric layer 18 on the graphene layer 16. In one example, the method comprises forming bottom electrodes by thermal evaporation of metal, and patterning the bottom electrode by electron-beam lithography. One or more additional top gates, side gates, back gates or a combination thereof may also be similarly fabricated. The method in the preferred form also includes spin-coating a thin film of poly(vinylidenefluoride-trifluoroethylene) P(VDF-TrFE) on the graphene layer or on the dielectric layer to form the ferroelectric layer. The arrangement of the graphene layer on the ferroelectric layer is one selected from: directly in contact with the ferroelectric layer, and separated by an ultrathin insulating layer.

The graphene layer is fabricated in one or more of the following ways: chemically derived from graphene oxide, fabricated from chemically modified graphene (e.g. graphane), and grown by one or more of chemical vapor deposition (CVD), low pressure CVD, or plasma-enhanced CVD on copper, nickel, cobalt or any other surface, which allows for large-scale graphene. The graphene layer may also be mechanically exfoliated from bulk graphite. The thickness of the graphene layer is selected from the group consisting of: one layer, two layers, three layers and any other gate tunable thickness.

The graphene layer may be a pristine two-dimensional sheet, or patterned into nanoscale dimensions of dots, dot arrays, nanowires or nanowire arrays. In terms of band gap, the graphene layer has an intrinsic energy band structure or has a band gap engineered by lateral confinement, strain stress or electric field.

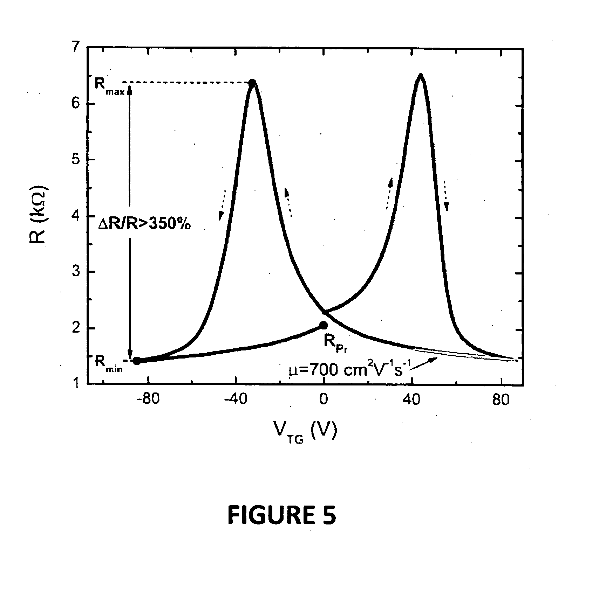

The electric hysteresis loop for the graphene resistance R as a function of top gate (i.e. top electrode) voltage $V_{TG}$ for one sample of the memory cell of Figure 1 is shown in Figure 5. It is notable that there are pronounced hysteresis in resistance measurements when the top gate voltage is swept in a closed loop. A hysteretic switching is shown between the maximum resistance $R_{max}$ and the minimum resistance $R_{min}$. For the sample tested, the resistance change ratio, $\Delta R/R = (R_{max}-R_{min})/R_{min}$ was larger than 350%.

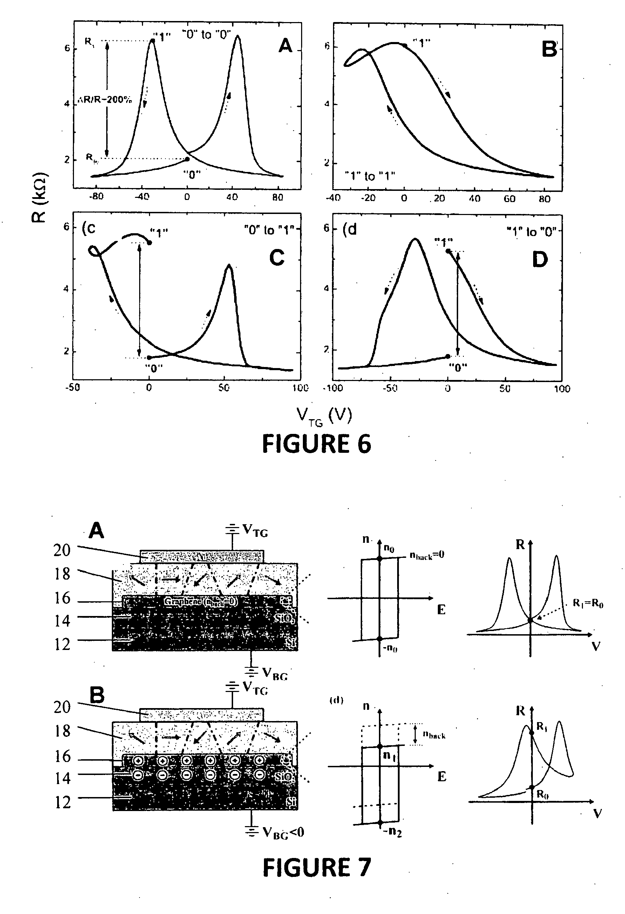

In the preferred embodiment, the maximum resistance peak $R_{max}$ represents the data value '1' while the data value '0' is represented by $R_{Pr}$. As shown in Figures 6A and 6D, a major hysteresis loop, corresponding to a full symmetrical $V_{TG}$ sweep sets the memory to '0', independent of the existing state. In Figure 6A, '0' has been rewritten into '0', while in Figure 6D, the data value has been reset from '1'-to-'0'. In contrast, writing '1' into the memory cell requires a minor hysteresis loop with an asymmetrical $V_{TG}$ sweep to minimize the polarization in the ferroelectric layer when $V_{TG}$ is back to zero. As shown in Figures 6B and 6C, a minor hysteresis loop sets the resistance state of the graphene channel to near $R_{max}$, independent of the initial state of '1' or '0'. Thus, using major and minor hysteresis loops, it is possible to realize nonvolatile switching or setting of values in the memory cell. As outlined earlier, the read out of the information set in the memory cell can be simply done by measuring the cell resistance using an excitation current as low as 1 nA.

The above embodiments clearly show that reversible nonvolatile switching between a high resistance state and a low resistance state in a graphene layer can been realized by implementing major or minor hysteresis loops. The resistance hysteresis loop and the switching between the high and low resistance states are due to the electric-dipole-induced doping in graphene by the ferroelectric thin film (i.e. hysteretic ferroelectric doping). In the samples prepared to date, the resistance change $\Delta R/R$ exceeds 500% (i.e. the resistance at the high resistance state is more than 6 times that of the low resistance state) and may be further improved by improving the quality of ferroelectric/graphene interface, the charge carrier mobility in graphene, and by increasing the remnant polarization of ferroelectric thin film. One approach to increase the remnant polarization of the ferroelectric layer is by applying a larger electric field. An alternative approach would be to prepare graphene sheets directly on ferroelectric substrates, which would allow the use of other ferroelectric materials with much higher remnant polarization. Another approach would be to open a band gap in the graphene layer, either by using bilayer graphene or graphene nanoribbons.

Although the above embodiments are workable using an asymmetrical writing strategy (i.e. using different hysteresis loops), the requirement of an asymmetrical writing strategy may complicate the device operations and circuit designs for memory and data storage applications. To address this, the present invention implements an electrostatic bias technique. Specifically the hysteretic ferroelectric doping in the graphene layer is modified unidirectionally by introducing a background doping level (herein $n_{back}$) in the graphene layer before the ferroelectric polarization, The $n_{back}$ exerts electrostatic forces/bias on the electric dipole flipping and produces asymmetrical remnant polarizations Pr' and Pr" in the ferroelectric layer.

The effect of the electrostatic bias technique is shown relative to a non-electrostatic-bias technique in Figures 7A and 7B. In both figures, the ferroelectric layer is illustrated with arrows showing directions of its electrical dipoles. Figure 7A shows the effect without electrostatic bias. The ferroelectric gating introduces two symmetrical zero-field doping levels in graphene with opposite signs. With symmetrical voltage sweeping, no resistance change is observed due to the ambipolar field dependent conductance in graphene. Figure 7B shows the effect with electrostatic bias. As described earlier, electrostatic bias as a result of background doping $n_{back}$ in graphene (electrostatic bias can also be provided by a ferroelectric gate) modifies the hysteretic ferroelectric doping unidirectionally, allowing two distinct resistance states to be realized with symmetrical voltage sweeping. The resistance change ratio ($\Delta R/R$) in this embodiment can be determined using equation (1) below.

$$\frac{\Delta R}{R} = \frac{R_1 - R_0}{R_0} = \frac{2n_{back}}{n_0 - n_{back}} \qquad\qquad (1)$$

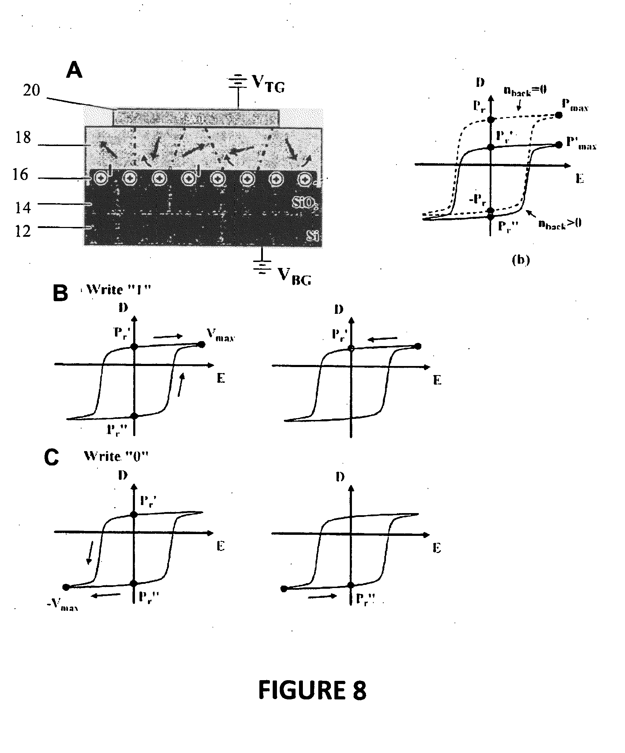

Using the electrostatic bias effect, symmetrical bit writing in the memory cell can be realized by symmetrical voltage pulses, which simplifies the writing procedures by applying voltage pulses to flip the electric dipole orientations in the ferroelectric layer. This is shown in Figures 8A to 8C. Figure 8A shows a cross-section schematic of the memory cell with the graphene layer having $n_{back}$ greater than zero, and the resulting effect of the $n_{back}$ of producing asymmetrical remnant polarizations Pr' and Pr" in the ferroelectric layer. With reference to Figures 8B and 8C, the memory cell in this embodiment is able to switch the memory states from '0' to '1' when a positive voltage pulse is applied to the top electrode. After the positive pulse, the polarization in the ferroelectric will remain at Pr', setting the graphene layer into the high resistance value, $R_1$ (as shown in Figure 7B). Conversely, to switch from '1' to '0', a negative voltage pulse is applied to the top electrode. After the negative pulse, the polarization in the ferroelectric will remain at Pr", setting the graphene layer into the low resistance value, $R_0$ (as shown in Figure 7B). In contrast, without electrostatic bias and where the field dependent conductance of the graphene is not bipolar, symmetrical writing would lead to the same resistance state due to symmetrical remnant polarizations of $P_r$ and $-P_r$ (as shown in Figure 7A).

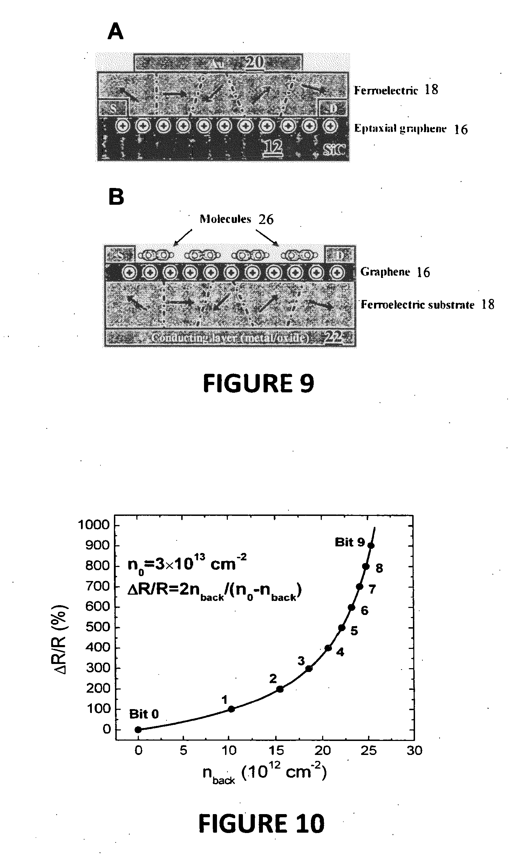

Non-volatile memory cell of two embodiments of the present invention utilizing electrostatic bias are shown in Figures 9A and 9B. In Figure 9A, the memory cell has a similar structure to that of Figure 1A but is formed by growing epitaxial graphene 16 on a silicon carbide (SiC) substrate 12. In this embodiment, the graphene layer 16 is doped (heavily in the preferred embodiment, represented by the positive ions in the layer 16) by the substrate 12 in a controlled manner by controlling the surface reconstruction of SiC. In Figure 9B, the graphene layer 16 is formed by chemical vapor deposition (CVD) or mechanical exfoliation on the ferroelectric layer 18, with the ferroelectric layer 18 acting as the substrate. In this embodiment, the graphene layer 16 is doped (heavily in the preferred embodiment) by donor/acceptor molecules 26, such as pentacene, rubrene or tetracyanoquinodimethane (TCNQ), and is arranged on one surface of the ferroelectric layer 18, with the bottom electrode 22 being formed on an opposite surface of the ferroelectric layer 18.

In another alternative embodiment of the present invention, the background doping level or $n_{back}$ in graphene is controlled such that the resistance change ratio ($\Delta R/R$) in memory cell is tuned continuously. The $n_{back}$ can be controlled by applying a back gate voltage ($V_{BG}$) to the substrate. For non-volatile applications, tunable $n_{back}$ can be provided using a ferroelectric back gate. Such a gate-tunable $\Delta R/R$ is advantageous as it allows multi-bit-per-cell data storage. The effect of a gate-tunable $\Delta R/R$ can be seen from Figure 10, which shows the relationship between $n_{back}$ and the resulting resistance change ratio $\Delta R/R$. Here, no ($P_r/e$) represents the zero-field ferroelectric doping in graphene when $n_{back}$=0. Specifically, by changing $n_{back}$ gradually, $\Delta R/R$ is tuned continuously from zero to over 1000% (although high mobility samples have shown a much larger range, e.g. to over 10000%). The different $\Delta R/R$ values are then used to represent multi-bit information storage. This is possible as an adjustment of $n_{back}$ produces different hysteresis loops with different values for $R_1$ and $R_0$. As each set of $R_1$ and $R_0$ allows a 1-bit storage by one specific $\Delta R/R$, multiple sets of $R_1$ and $R_0$ results in the ability to store multiple bits. For example, if three sets of $R_1$ and $R_0$ are detectable, a 3-bit storage (i.e. 00, 01, and 10) may be implemented. In the example of Figure 10, a 10-bit-per-cell tuning is shown, in which every 100% change in $\Delta R/R$ is defined as a bit. Compared to binary information, a 10-bit-per-cell storage increases data storage capacities by 5 times with the same unit cell size. This can be enhanced and utilized even more so using very high mobility devices where the resistance change ratio is 10000 or more. Furthermore, if band gap opening (e.g. lateral confinement, ribbons, dots and antidote arrays) is used, desirable changes may be made in the graphene band structure (e.g. hydrogenation, electric field induced gap, e.g. bilayer).

The benefits arising from the present invention will be clear from the foregoing description. For instance, by utilizing the field-dependent electrical resistance of a graphene layer, the non-volatile memory cell is fast enough to match the current DRAM. Both the writing and reading process in the memory cell of the present invention is realized by low working bias, which accordingly reduces power consumption of devices using the memory cell. In the case of graphene-P(VDF-TrFE) memory, for reading, a few tens of μV are required to read the resistance value of the graphene working channel; while for writing, less than 10 V working bias is achievable by limiting the P(VDF-TrFE) thickness below 100 nm. It will be appreciated that an organic ferroelectric layer allows also for simple integration with flexible transparent electronics and acts simultaneously also as a capping and passivation layer. Furthermore, data readings from the memory cell of the present invention are not destructive and thus no following re-writing is required. This increases the switching cycles and reduces power usage. Due to the stable, chemically inert properties of graphene, the memory cell of the present invention provides a reliable data storage means even when compared to conventional data storage. Graphene, which has an ultra-high charge carrier mobility, also gives the memory cell extremely fast reading speed, typically several tens of femtoseconds. Even if these speeds are not utilized due to design constrains of an actual working device, the fact that these devices have very high mobilities translate to large power savings when they are operated at orders of magnitude slower speeds. These factors when combined with the sensitive field-dependent electrical resistance of the graphene layer and the fast switching time of the ferroelectric layer (several tens of nanoseconds) provide a memory device that has high performance, fast access times, high reliability, low power consumption and non-volatility. For the graphene-ferroelectric memory cell, P(VDF-TrFE) is preferable for integration with flexible electronics with cost-effective solution for non-volatile data storage, while inorganic ferroelectric, such as lead zirconate titanate (PZT) based materials, is preferred when high performance, ultra-fast reading & writing graphene-ferroelectric memory is needed (in the case of PZT-based material, the switching speed can be as fast as 280 ps). In other words, the ferroelectric gate may be made out of inorganic or organic materials.

To summarize the above:

Graphene memory relies on the electronic intrinsic properties of the material. The carrier concentration can be tuned by means of an electric field effect. At large carrier concentrations (high doping) the device resistance is low. At low carrier concentration (small doping) the device resistance small. Independent of the doping, the carrier mobilities of graphene are large. The two resistance states can be used to store information, such that a large resistance state is 'donated' to one bit of information and a small resistance to the complimentary bit of information.

The device state can be switched from one state to another by changing the carrier concentration by electric field effect, provided by electric gates.

The electric field effect can be realized with non-volatiles gates.

In the presence of non-volatile gates, the memory will be non-volatile memory.

The non-volatile gate can be realized by ferroelectric materials.

The device operation can be such that one uses a ferroelectric gate to an already charged graphene sheet. This charging can be achieved by a number of ways (substrate induced, e.g. SiC, backgate induced chemical doping induced, or any combination of these). This has been herein referred to as 'electrostatic bias' and leads to a simple read write scheme (symmetric writing).

With electrostatic bias, it is possible to achieve a gate tunable $\Delta R/R$ which can vary over many orders of magnitude (at least 1000%, in very high quality samples 100000% and in bandgap engineered samples >>10000%).

It is also possible to construct a multilayer graphene memory cell. The structure in this alternative embodiment would consist of an alternating stack of graphene and ferroelectric gate, each layer contacted separately and hence a 3D memory architecture is achieved, where each layer forms a unit cell. This may be implemented using graphene or graphene oxide, e.g. by spin-coating the graphene and ferroelectric gate layer by layer.

In a further alternative embodiment, organic ferroelectric materials are used which are transparent and flexible to provide a capping layer for flexible, transparent electronic devices based on graphene (if graphene is also used as a contact metal for the gates).

The foregoing describes non-limiting preferred embodiments, which, as will be understood by those skilled in the art, may be subject to variations or modifications in design, construction or operation without departing from the scope of the claims. Also, where a ferroelectric gate is used, it is not essential that zero remnant polarization and non-zero remnant polarization be used to define each of the binary values '1' and '0'. Where necessary or desired, one remnant polarization may be defined such that the resulting resistance of the graphene sheet at that polarization represents one data value, and the absence of that polarization (resulting in other values of resistance) may represent another data value. Changing from non-zero remnant polarization to substantially zero polarization may be accomplished via known depolarization techniques. In addition, although the x-axis of the graphs of Figures 3A and 3B have been described as the polarization of the ferroelectric layer, skilled persons will appreciate that the x-axis may also represent the bottom gate voltage ($V_{BG}$ in Figure 1A) or the top gate voltage ($V_{TG}$ in Figure 1A). That is to say, the field-dependent resistance characteristic of the graphene layer may be expressed in terms of the voltage applied to the top or bottom gate of the memory cell in addition to the polarization of the ferroelectric layer. Where an insulating substrate is desirable, this may be flexible and/or transparent. If a backgate is desirable, the arrangement may be such that the graphene sits on the bottom gate structure comprising of a highly conducting layer separated from the graphene by an insulating layer. The above variations, for instance, are intended to be covered by the scope of the claims.

## Claims

1. A non-volatile memory cell (10) comprising a graphene layer (16) having controllable resistance states representing data values of the memory cell (10); and a ferroelectric layer (18) configured to control the resistance states, **characterized in that** the graphene layer (18) includes a background doping level ($n_{back}$) greater than zero, the background doping level ($n_{back}$) being introduced before polarization of the ferroelectric layer (18).

**EP 2 345 071 B1**

**2.** The non-volatile memory cell (10) of claim 1 wherein the graphene layer (16) is configured to be in a high resistance state when a positive voltage pulse is applied to a top electrode (20) of the memory cell (10), and wherein the graphene layer (16) is configured to be in a low resistance state when a negative voltage pulse is applied to the top electrode (20).

**3.** The non-volatile memory cell (10) of claim 1 or 2 wherein the graphene layer (16) is epitaxial graphene (16) on a SiC substrate (12).

**4.** The non-volatile memory cell (10) of claim 1 or 2 wherein the graphene layer (16) is doped with donor or acceptor molecules and is arranged on one surface of the ferroelectric layer (18), and with an electrode (22) being formed on an opposite surface of the ferroelectric layer (18).

**5.** The non-volatile memory cell (10) of any one of claims 1 to 4 wherein the background doping level is controllable to adjust a resistance change ratio of the resistance states.

**6.** The non-volatile memory cell (10) of claim 5 wherein multiple resistance change ratios represent multiple bits of data.

**7.** The non-volatile memory cell (10) of claim 1 or 2 wherein the graphene layer (16) is chemically derived from graphene oxide; or is chemically modified graphene.

**8.** The non-volatile memory cell (10) of claim 1 or 2 wherein the graphene layer (16) is grown by chemical vapor deposition CVD, low pressure CVD, or plasma-enhanced CVD on copper, nickel, cobalt or any other surface, which allows for large-scale graphene.

**9.** The non-volatile memory cell (10) of claim 1 or 2 wherein the graphene layer (16) is one layer, two layers, three layers or any other gate tunable thickness.

**10.** The non-volatile memory cell (10) of claim 1 or 2 wherein the graphene layer (16) is a pristine two-dimensional sheet, or patterned into nanoscale dimensions of dots, dot arrays, nanowires or nanowire arrays.

**11.** The non-volatile memory cell (10) of claim 1 or 2 wherein the graphene layer (16) has an intrinsic energy band structure or has a band gap engineered by lateral confinement strain stress or electric field.

**12.** The non-volatile memory cell (10) of claim 1 or 2 wherein the graphene layer (10) is gated by top gates, side gates, back gates or a combination of one or more of top gates, back gates and side gates.

**13.** The non-volatile memory cell (10) of claim 1 or 2 wherein the memory cell (10 is fabricated on a flexible and/or transparent substrate (12).

**14.** The non-volatile memory cell (10) of claim 1 or 2 wherein the arrangement of the graphene layer (16) is one selected from: directly in contact with the ferroelectric layer (18), and separated by an ultrathin insulating layer.

**15.** The non-volatile memory cell (10) of any one of the preceding claims further comprising an alternating stack of graphene layer (16) and ferroelectric layer (18), each layer (16,18) being contacted separately.

**16.** A method of fabricating a non-volatile memory cell (10) comprising providing a graphene layer (16) having controllable resistance states to represent data values of the memory cell (10); and providing a ferroelectric layer (18) configured to control the resistance states, **characterized in that** the graphene layer (16) includes a background doping level ($n_{back}$) greater than zero, and the method includes introducing the background doping level ($n_{back}$) before polarization of the ferroelectric layer (18).

**Patentansprüche**

**1.** Nichtflüchtige Speicherzelle (10), umfassend eine Graphenschicht (16) mit steuerbaren Widerstandszuständen, die Datenwerte der Speicherzelle (10) repräsentieren; und eine ferroelektrische Schicht (18), die konfiguriert ist, um die Widerstandszustände zu steuern, **dadurch gekennzeichnet, dass** die Graphenschicht (18) ein Hintergrunddotierungsniveau ($n_{back}$) größer als null enthält, wobei das Hintergrunddotierungsniveau ($n_{back}$) vor der Polarisation der ferroelektrischen Schicht (18) eingeführt wird.

2. Nichtflüchtige Speicherzelle (10) nach Anspruch 1, wobei die Graphenschicht (16) konfiguriert ist, um in einem hohen Widerstandszustand zu sein, wenn ein positiver Spannungsimpuls an eine obere Elektrode (20) der Speicherzelle (10) angelegt wird, und wobei die Graphenschicht (16) konfiguriert ist, um in einem niedrigen Widerstandszustand zu sein, wenn ein negativer Spannungsimpuls an die obere Elektrode (20) angelegt wird.

3. Nichtflüchtige Speicherzelle (10) nach Anspruch 1 oder 2, wobei die Graphenschicht (16) epitaktisches Graphen (16) auf einem SiC-Substrat (12) ist.

4. Nichtflüchtige Speicherzelle (10) nach Anspruch 1 oder 2, wobei die Graphenschicht (16) mit Donator- oder Akzeptormolekülen dotiert ist und auf einer Oberfläche der ferroelektrischen Schicht (18) angeordnet ist, und wobei eine Elektrode (22) auf einer gegenüberliegenden Oberfläche der ferroelektrischen Schicht (18) gebildet ist.

5. Nichtflüchtige Speicherzelle (10) nach einem der Ansprüche 1 bis 4, wobei das Hintergrunddotierungsniveau steuerbar ist, um ein Widerstandsänderungsverhältnis der Widerstandszustände anzupassen.

6. Nichtflüchtige Speicherzelle (10) nach Anspruch 5, wobei mehrere Widerstandsänderungsverhältnisse mehrere Datenbits repräsentieren.

7. Nichtflüchtige Speicherzelle (10) nach Anspruch 1 oder 2, wobei die Graphenschicht (16) chemisch von Graphenoxid abgeleitet ist; oder chemisch modifiziertes Graphen ist.

8. Nichtflüchtige Speicherzelle (10) nach Anspruch 1 oder 2, wobei die Graphenschicht (16) durch chemische Aufdampfung bzw. CVD, Niederdruck-CVD oder CVD im Plasma auf Kupfer, Nickel, Cobalt oder einer beliebigen anderen Oberfläche, die umfangreiches Graphen gestattet, gezüchtet ist.

9. Nichtflüchtige Speicherzelle (10) nach Anspruch 1 oder 2, wobei die Graphenschicht (16) eine Schicht, zwei Schichten, drei Schichten oder eine beliebige andere Gatter-abstimmbare Dicke aufweist.

10. Nichtflüchtige Speicherzelle (10) nach Anspruch 1 oder 2, wobei die Graphenschicht (16) eine unverfälschte Folie ist oder im Nanometerbereich-Maßstab mit Punkten, Punktanordnungen, Nanodrähten oder Nanodrahtanordnungen gemustert ist.

11. Nichtflüchtige Speicherzelle (10) nach Anspruch 1 oder 2, wobei die Graphenschicht (16) eine innewohnende Energiebandstruktur aufweist oder eine durch Lateralbegrenzung, Dehnungsspannung oder elektrisches Feld konstruierte Bandlücke aufweist.

12. Nichtflüchtige Speicherzelle (10) nach Anspruch 1 oder 2, wobei die Graphenschicht (16) durch obere Gatter, seitliche Gatter, hintere Gatter oder einer Kombination von einem oder mehreren von oberen Gattern, hinteren Gattern und seitlichen Gattern gattergesteuert ist.

13. Nichtflüchtige Speicherzelle (10) nach Anspruch 1 oder 2, wobei die Speicherzelle (10) auf einem flexiblen und/oder transparenten Substrat hergestellt wird.

14. Nichtflüchtige Speicherzelle (10) nach Anspruch 1 oder 2, wobei die Anordnung der Graphenschicht (16) eine aus Folgendem ausgewählte ist: direkt in Kontakt mit der ferroelektrischen Schicht (18) und getrennt durch eine ultradünne isolierende Schicht.

15. Nichtflüchtige Speicherzelle (10) nach einem der vorstehenden Ansprüche, ferner umfassend einen abwechselnden Stapel von Graphenschicht (16) und ferroelektrischer Schicht (18), wobei jede Schicht (16, 18) separat in Kontakt gebracht wird.

16. Verfahren zum Herstellen einer nichtflüchtigen Speicherzelle (10), umfassend, eine Graphenschicht (16) mit steuerbaren Widerstandszuständen bereitzustellen, um Datenwerte der Speicherzelle (10) zu repräsentieren; und eine ferroelektrische Schicht (18) bereitzustellen, die konfiguriert ist, um die Widerstandszustände zu steuern, **dadurch gekennzeichnet, dass** die Graphenschicht (18) ein Hintergrunddotierungsniveau ($n_{back}$) größer als null enthält, und wobei das Verfahren enthält, das Hintergrunddotierungsniveau ($n_{back}$) vor der Polarisation der ferroelektrischen Schicht (18) einzuführen.

**Revendications**

1. Cellule de mémoire non volatile (10) comprenant une couche de graphène (16) présentant des états de résistance commandables représentant des valeurs de données de la cellule de mémoire (10) ; et une couche ferroélectrique (18) configurée de manière à commander les états de résistance, **caractérisée en ce que** la couche de graphène (18) comprend un niveau de dopage de fond ($n_{back}$) supérieur à zéro, le niveau de dopage de fond ($n_{back}$) étant introduit avant la polarisation de la couche ferroélectrique (18).

2. Cellule de mémoire non volatile (10) selon la revendication 1, dans laquelle la couche de graphène (16) est configurée de manière à être dans un état de résistance élevé lorsqu'une impulsion de tension positive est appliquée à une électrode supérieure (20) de la cellule de mémoire (10), et dans laquelle la couche de graphène (16) est configurée de manière à être dans un état de résistance faible lorsqu'une impulsion de tension négative est appliquée à l'électrode supérieure (20).

3. Cellule de mémoire non volatile (10) selon la revendication 1 ou 2, dans laquelle la couche de graphène (16) représente du graphène épitaxié (16) sur un substrat de carbure de silicium, SiC (12).

4. Cellule de mémoire non volatile (10) selon la revendication 1 ou 2, dans laquelle la couche de graphène (16) est dopée avec des molécules de types donneurs ou accepteurs, et est agencée sur une surface de la couche ferroélectrique (18), et avec une électrode (22) formée sur une surface opposée de la couche ferroélectrique (18).

5. Cellule de mémoire non volatile (10) selon l'une quelconque des revendications 1 à 4, dans laquelle le niveau de dopage de fond peut être commandé de manière à régler un taux de variation de résistance des états de résistance.

6. Cellule de mémoire non volatile (10) selon la revendication 5, dans laquelle de multiples taux de variation de résistance représentent de multiples bits de données.

7. Cellule de mémoire non volatile (10) selon la revendication 1 ou 2, dans laquelle la couche de graphène (16) est chimiquement dérivée de l'oxyde de graphène ; ou est du graphène chimiquement modifié.

8. Cellule de mémoire non volatile (10) selon la revendication 1 ou 2, dans laquelle la couche de graphène (16) est cultivée par dépôt chimique en phase vapeur, CVD, par dépôt CVD à basse pression, ou par dépôt CVD activé par plasma sur du cuivre, du nickel, du cobalt, ou une quelconque autre surface, autorisant du graphène à grande échelle.

9. Cellule de mémoire non volatile (10) selon la revendication 1 ou 2, dans laquelle la couche de graphène (16) présente une couche, deux couches, trois couches ou une quelconque autre épaisseur réglable par grille.

10. Cellule de mémoire non volatile (10) selon la revendication 1 ou 2, dans laquelle la couche de graphène (16) est une feuille bidimensionnelle vierge, ou est modelée en des dimensions nanométriques de points, de matrices de points, de nanofils ou de matrices de nanofils.

11. Cellule de mémoire non volatile (10) selon la revendication 1 ou 2, dans laquelle la couche de graphène (16) présente une structure de bande d'énergie intrinsèque ou présente une bande interdite réalisée par confinement latéral, par contrainte / déformation ou par un champ électrique.

12. Cellule de mémoire non volatile (10) selon la revendication 1 ou 2, dans laquelle la couche de graphène (10) est bloquée par des grilles supérieures, des grilles latérales, des grilles arrière ou une combinaison d'une ou plusieurs des grilles supérieures, des grilles arrière et des grilles latérales.

13. Cellule de mémoire non volatile (10) selon la revendication 1 ou 2, dans laquelle la cellule de mémoire (10) est fabriquée sur un substrat flexible et/ou transparent (12).

14. Cellule de mémoire non volatile (10) selon la revendication 1 ou 2, dans laquelle l'agencement de la couche de graphène (16) est un agencement sélectionné parmi les suivants : un agencement directement en contact avec la couche ferroélectrique (18), et un agencement séparé par une couche isolante ultramince.

**15.** Cellule de mémoire non volatile (10) selon l'une quelconque des revendications précédentes, comprenant en outre un empilement alterné de couche de graphène (16) et de couche ferroélectrique (18), chaque couche (16, 18) étant mise en contact séparément.

**16.** Procédé de fabrication d'une cellule de mémoire non volatile (10) comprenant la fourniture d'une couche de graphène (16) présentant des états de résistance commandables destinés à représenter des valeurs de données de la cellule de mémoire (10) ; et la fourniture d'une couche ferroélectrique (18) configurée de manière à commander les états de résistance, **caractérisé en ce que** la couche de graphène (16) inclut un niveau de dopage de fond ($n_{back}$) supérieur à zéro, et **en ce que** le procédé comprend l'introduction du niveau de dopage de fond ($n_{back}$) préalablement à la polarisation de la couche ferroélectrique (18).

$V_{TG}$

Dielectric

Conducting Layer

$V_{BG}$

**FIGURE 1A**

**FIGURE 1B**

Dirac point

Resistance (kΩ)

Hole doping    Electron doping

Gate Voltage (V)

**FIGURE 2**

FIGURE 3

16 15 17

S D

20

18

14

Dielectric

12

Conducting Layer

**FIGURE 4A**

15 17

S D

Graphene 16

Epitaxial ferroelectric 18

Conducting perovskite oxide 12

**FIGURE 4B**

17

16

18

12

24 15

**FIGURE 4C**

**FIGURE 5**

FIGURE 6

FIGURE 7

**FIGURE 8**

**A**

Ferroelectric 18

Eptaxial graphene 16

**B**

Molecules 26

Graphene 16

Ferroelectric substrate 18

# FIGURE 9

$n_0 = 3 \times 10^{13}$ cm$^{-2}$

$\Delta R/R = 2n_{back}/(n_0 - n_{back})$

# FIGURE 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2009140596 A

### Non-patent literature cited in the description

- High mobility multi-layer graphene field effect transistors fabricated on epitaxial ferroelectric gate oxides. **HONG et al.** 15th International Workshop on Oxide Electronics. ESTES Park, Co, 17 September 2008, 136808-1136808-4

- **ECHTERMEYER.** Non-volatile switching in graphene field effect devices. *IEEE Electron Device Letters,* August 2008, vol. 29 (8), 952-954
- **PETER C. EKLUND.** Graphene Electronics. *NSF Nanoscale Science and Engineering Grantees Conference,* 03 December 2001